# EUROPÄISCHE PATENTSCHRIFT

(11) **EP 3 970 147 B1**
(45) Veröffentlichungstag und Bekanntmachung des Hinweises auf die Patenterteilung: **25.06.2025**
(21) Anmeldenummer: 20726677.6
(22) Anmeldetag: 21.04.2020
(51) Int. Cl.: G11C 13/00, G11C 13/04, G11C 11/22, G11C 11/56

(54) **PHASENWECHSELSPEICHER**
PHASE-CHANGE MEMORY
MÉMOIRE À CHANGEMENT DE PHASE

(30) Priorität: 16.05.2019 DE 102019112887
(43) Veröffentlichungstag der Anmeldung: 23.03.2022
(73) Patentinhaber: Rheinisch-Westfälische Technische Hochschule (RWTH) Aachen, 52062 Aachen (DE)
(72) Erfinder: WEI, Shuai, 52074 Aachen (DE); WUTTIG, Matthias, 52074 Aachen (DE); CHENG, Yudong, 52074 Aachen (DE); PRIES, Julian, 52074 Aachen (DE); LU, Xiaoling, 52070 Aachen (DE)
(74) Vertreter: Cohausz Hannig Borkowski Wißgott
(86) Internationale Anmeldenummer: PCT/DE2020/100324
(87) Internationale Veröffentlichungsnummer: WO 2020/228889

(56) Entgegenhaltungen:
- WO-A1-2016/111724
- DE-A1- 102017 208 205
- DE-A1- 2 138 581
- US-A- 3 271 591
- US-A1- 2010 073 997
- US-A1- 2015 154 120

## Beschreibung

### Technisches Gebiet

Die Erfindung betrifft einen Phasenwechselspeicher zum nichtflüchtigen Speichern von binären Inhalten, welcher die Information durch lokales Schalten eines Materials zwischen einer amorphen und einer kristallinen Phase elektrisch und/oder optisch nichtflüchtig speichert, wobei der Zustand bezüglich der elektrischen Leitfähigkeit des Materials und/oder bezüglich der Reflexionseigenschaften des Materials den Informationsgehalt des Phasenwechselspeichers festlegt.

Weiterhin betrifft die Erfindung ein Verfahren für einen Phasenwechselspeicher zum nichtflüchtigen Speichern von binären Inhalten, welcher die binären Inhalte durch lokales Schalten eines Materials zwischen einer amorphen und einer kristallinen Phase elektrisch und/oder optisch nichtflüchtig speichert, wobei der Zustand bezüglich der elektrischen Leitfähigkeit des Materials und/oder bezüglich der Reflexionseigenschaften des Materials den Informationsgehalt des Phasenwechselspeichers festlegt.

### Beschreibung

Phasenwechselspeicher (PCMs) wechseln zwischen amorphen und kristallinen Strukturen. Sie lassen sich beispielsweise als Energie- oder als Datenspeicher einsetzen. Hier sei der Phasenwechselspeicher als Datenspeicher für binäre Inhalte bzw. digitale Informationen betrachtet.

Es wird zwischen flüchtigen und nichtflüchtigen Daten- bzw. Arbeitsspeichern bei elektronischen Einheiten, wie z.B. mikroprozessorgesteuerten elektronischen Datenverarbeitungsanlagen bzw. Computern, unterschieden. Flüchtige Speicher, wie Halbleiterspeicher mit direktem Zugriff auch RAM (engl. Random Access Memory) genannt, haben die Eigenschaft, dass sie ihre gespeicherten Inhalte verlieren, sobald die Spannung ausgeschaltet wird. Die Speicherinhalte sind somit nur temporär in dem Speicher gespeichert. Ein nichtflüchtiger Speicher wie z.B. ROM (engl. Read-Only-Memory), EPROM (engl. Eraseable-programmable-ROM) oder EEPROM (engl. Electrically eraseable programmable-ROM) behält hingegen seine Inhalte auch nach einem Ausschalten der Spannung.

Nichtflüchtige Speicher sind beispielsweise aber auch magnetische Datenbänder, Disketten oder Festplatten, die ihre Daten auf elektromagnetische Weise auf einem magnetisierbaren Speichermedium speichern. Optische Speichermedien die die Daten nichtflüchtig speichern sind beispielsweise CDs bzw. DVDs. Als nichtflüchtige digitale Halbleiterbausteine ist hier zudem der Flash-Speicher zu erwähnen. Das Schreiben bzw. das Speichern von Informationen in solchen digitalen Speichermedien benötigt immer eine gewisse Zeit.

Die Speicherzeit ist dabei insbesondere von den jeweiligen Schaltzeiten der Speichermedien abhängig. Diese Schaltzeiten werden neben der Materialeigenschaft selbst beispielsweise auch von der Temperatur beeinflusst. Je mehr bzw. je schneller Schaltvorgänge erfolgen, desto mehr Wärme wird von den Bauteilen produziert und umso langsamer werden oft die Schaltvorgänge des Speichers, sofern die Wärme nicht abtransportiert wird. Gerade Halbleiterbauteile sind sehr temperaturabhängig und müssen in der Regel daher relativ stark gekühlt werden.

Um die Geschwindigkeit bei nichtflüchtigen Speichermedien trotzdem zu steigern sind daher neue Speicherkonzepte, wie beispielsweise die der oben erwähnten Phasenwechselspeicher (PCM), entwickelt worden. Dabei sind auch solche Phasenwechselspeicher, wie sie oben genannt sind, mittlerweile in Serienfertigung und im Einsatz bei Computern. Die Firma Intel Corporation bietet solche Phasenwechselspeicher unter dem Namen "Intel Optane^{®}" an.

Bei den Phasenwechselspeichern wird sich zunutze gemacht, dass ein Material unterschiedliche optische und/oder elektrische Eigenschaften in der amorphen bzw. der kristallinen Phase aufweist. Durch anlegen von zwei Elektroden kann ein Strompuls auf das Material des Phasenwechselspeichers gegeben werden. Wenn das Material mit einem relativ hohen Strompuls beaufschlagt wird, entsteht Wärme, so dass das kristalline Material in die amorphe Phase wechselt. Nach dem Ende des Pulses kühlt sich das Material sehr schnell ab. Das Material verharrt daher im amorphen Zustand und fällt nicht in die kristalline Phase zurück. Die Leitfähigkeit ist dabei im amorphen Zustand erheblich schlechter, als im kristallinen Zustand des Materials.

Der kristalline Zustand wird meist auch als der gesetzte Zustand, der "SET state", bezeichnet. Das Material gelangt aus dem amorphen Zustand wieder zurück in den gesetzten, kristallinen Zustand, indem es nun einem längeren relativ niedrigen Strompuls ausgesetzt ist. Der Vorgang vom amorphen in den kristallinen Zustand lässt sich somit über die Dauer und Amplitude des Strompulses umkehren. Dadurch wird das amorphe Material über die Kristallisationstemperatur erhitzt und so lange auf dieser Temperatur gehalten, bis Kristallisation stattfindet. Das Material bildet so eine Speicherzelle, die über ihren Phasenzustand den binären Inhalt definiert.

Zum Auslesen der Information wird über eine solche resistive Speicherzelle eine Spannung angelegt, die eine so geringe Stromstärke bewirkt, dass die Temperatur im Material nicht die für einen Phasenwechsel notwendige Höhe erreicht. Je nach Zustand fließt dabei ein anderer Strom, was zum Auslesen genutzt wird. Damit lässt sich über den Widerstand der Speicherzelle ein binärer Zustand festlegen. Im kristallinen Zustand wird der "SET state", eine binäre "Eins", und im amorphen Zustand eine binäre "Null" definiert. Viele solcher Speicherzellen werden zu einem nichtflüchtigen digitalen Speicher für Datenverarbeitungsanlagen mit Mikroprozessoren eingesetzt.

### Stand der Technik

In der DE 10 2008 016 522 A1 wird eine Speicherzelle offenbart. Die dort beschriebene Speicherzelle umfasst eine erste Elektrode und eine zweite Elektrode, Weiterhin ist ein Verbundmaterial vorgesehen, wobei das Verbundmaterial die erste Elektrode elektrisch mit der zweiten Elektrode verbindet und ein Phasenwechselmaterial und ein Resistormaterial enthält. Dabei ist mindestens ein Teil des Phasenwechselmaterials in der Lage auf das Anlegen eines Schaltsignals an die erste und/oder die zweite Elektrode anzusprechen, so dass zwischen einer im Wesentlichen kristallinen Phase und einer im Wesentlichen amorphen Phase gewechselt werden kann. Dabei weist das Resistormaterial eine Resistivität auf, die geringer ist als diejenige des Phasenwechselmaterials, wenn das Phasenwechselmaterial in der im Wesentlichen amorphen Phase vorliegt.

Aus der US 3 271591 A ist ein schaltbares Halbleiterbauelement bekannt. Die für die Halbleiterelemente verwendeten Halbleiterstoffe können verschiedenartig aufgebaut sein. Als Speichertypen dienen Halbleiterstoffe, die im Sperrzustand amorph sind und bei denen im Leiterzustand mindestens ein für den Stromfluss dienender Pfad kristallin ausgebildet ist. Als nichtspeichernde Schalttypen dienen Halbleiterstoffe, die im Sperrzustand sowohl kristallin als auch amorph ausgebildet sein können. Der Halbleiter befindet sich jedoch entweder im n-leitenden oder im p-leitenden Zustand. Die Festkörper-Halbleiterstoffe können derart ausgewählt werden, dass sie eine intermolekulare

Bandstruktur mit einer großen Anzahl von Ladungsträger-Haftstellen dank gestörter Ketten oder Ringstrukturen oder gestörter Atomstrukturen aufweisen, die durch Behandeln in der gleichen oder in verschiedenen Weisen hergestellt werden können, wie z.B. Verwendung unreiner Stoffe, Hinzufügung von Unreinheiten, Ablagern auf Unterschichten, Einschluss von Oxyden in die Masse und/oder in die Oberfläche oder Grenzflächen, mechanisch durch Bearbeitung, Sandstrahlen, Schlagen, Biegen, Ätzen oder Behandlung mittels Ultraschall oder Herstellung physikalischer Gitterverformungen durch metallurgische Massnahmen, wie z.B. Erhitzung und schnelles Abschrecken etc.

Die DE 21 38 581 A1 offenbart ein Speichermaterial mit amorpher und kristalliner Struktur. Typische Form-Gestalt- und Lageänderung des Speichermaterials können dabei eingeschlossen werden, z.B. durch Änderungen aus einem allgemein amorphen Zustand in einen geordneteren oder kristallinartigen Zustand, der verschiedene kristalline Zustände umfassen kann, oder umgekehrt. Die Schicht aus Speichermaterial ist mit einem katalytischen Material ausgestattet, das fähig ist, die inneren Vorspannungskräfte (die Kristallisationskräfte) relativ zu erhöhen und die inneren Hemmkräfte gegen die Wirkung der Vorspannkräfte (die kristallisationshemmenden Faktoren) zu vermindern, wenn das Speichermaterial aktiviert wird. Wenn der Speichermaterialschicht Energie zugeführt wird, wird das katalytische Material in Teilen der Schicht aktiviert und ändert diese Teile der Schicht und führt sie aus dem einen in den anderen der feststellbaren Strukturzustände über. Einige aktivierte katalytische Materialien können in erster Linie die inneren Vorspannkräfte erhöhen, während andere in erster Linie die inneren Hemmfaktoren gegen die Wirkung der inneren Vorspannkräfte vermindern. Das Katalysatormaterial kann auch die Zahl von Kernen sowie die Größe der an diesen gebildeten Kristallen steuern. Die zur Wirkung gebrachte Energie kann elektrische Energie, Strahlungsenergie, Elektronenstrahlenenergie, elektromagnetische Energie; einschließlich Wärme, sichtbares Licht oder Ultraviolettenergie, akustische Energie, mechanische Spannungs- oder Druckenergie, chemische Energie o.dgl. sowie eine Kombination dieser Energieformen sein.

In der US 2010/073997 A1 wird eine piezoelektrisch programmierte, nichtflüchtige Speicherzellenstruktur beschrieben. Phasenwechselmaterial kann zwischen zwei diskreten Zuständen umgewandelt werden, amorphen (hoher elektrischer Widerstand) und kristallinen (niedriger elektrischer Widerstand), was die Speicherung von Daten ermöglicht. Der Umwandlungs- oder Schreibprozess für diese beispielhaften Materialien erfolgt durch thermische Wechselbeanspruchung des Phasenwechselmaterials. Die Speicherzellenstruktur umfasst ein programmierbares piezo-resistives hysteretisches Material (PRHM), das in einen Zustand mit niedrigem Widerstand und in einen Zustand mit hohem Widerstand umgewandelt werden kann. Ein piezoelektrisches Material ist mechanisch mit dem PHRM gekoppelt.

Durch eine angelegte Spannung an das piezoelektrische Material wird entweder eine Zug- oder eine Druckspannung auf den PRHM ausgeübt, abhängig von der Polarität der angelegten Spannung. Eine oder mehrere Elektroden sind elektrisch mit dem PRHM verbunden. Dabei sind die eine oder die mehreren Elektroden so konfiguriert, dass sie einen Schreibprogrammier- Strompfad durch das piezoelektrische Material und einen Lese-Strompfad durch das PRHM bereitzustellen.

Die DE 10 2017 208 205 A1 betrifft ein Filterelement mit veränderbarem Filterbereich. Das Filterelement umfasst eine Filterlage, die als ein Verbund aus einem als akustischer Resonator fungierenden piezoelektrischen Material und einem Phasenwechselmaterial ausgeführt ist. Das Phasenwechselmaterial ist ausgebildet, um temperaturabhängig zwischen zumindest einer ersten Phase und einer zweiten Phase zu wechseln, wobei die Filterlage im Zustand der ersten Phase eine andere Übertragungscharakteristik als im Zustand der zweiten Phase aufweist. Darüber hinaus weist das Filterelement eine Heizlage zum Ändern einer Temperatur des Phasenwechselmaterials auf.

Die bekannten Phasenwechselspeicher haben den Nachteil, dass sie trotz ihrer Vorzüge noch zu langsam sind. Wünschenswert sind nichtflüchtige Speicher, die erheblich schneller als bspw. Flash-Speicherbausteine sind. Bekannte Phasenwechselspeicher, wie der 3D Xpoint "Intel Optane^{®}", sind zwar erheblich schneller, doch reicht in manchen Anwendungsgebieten selbst diese Schaltgeschwindigkeit nicht aus. Die Phasenwechselspeicher werden aufgrund ihrer Kristallisationsgeschwindigkeit nämlich in ihrer Schaltgeschwindigkeit begrenzt.

### Offenbarung der Erfindung

Aufgabe der Erfindung ist es daher, die Nachteile des Standes der Technik zu vermeiden und einen Phasenwechselspeicher für Datenverarbeitungsanlagen zu schaffen, dessen Schaltzeiten erheblich verkürzt sind.

Die Erfindung ist in den beigefügten Ansprüchen 1 bis 5 definiert.

Erfindungsgemäß wird die Aufgabe dadurch gelöst, dass bei einem Phasenwechselspeicher konfiguriert zum nichtflüchtigen Speichern von binären Inhalten der eingangs genannten Art ein Ultraschallgenerator mit einer piezoelektrischen Einheit vorgesehen Ist, der zumindest während des Schaltvorgangs das Phasenwechselmaterial mit Ultraschall beaufschlagt und somit den Schaltvorgang beschleunigt.

Weiterhin wird die Aufgabe durch ein Verfahren für einen Phasenwechselspeicher zum nichtflüchtigen Speichern von binären Inhalten der eingangs genannten Art gelöst, bei dem Ultraschall erzeugt wird, mit dem das Phasenwechselmaterial zumindest während des Schaltvorgangs beaufschlagt wird und somit den Schaltvorgang beschleunigt, wobei der Ultraschall mit einer piezoelektrischen Einheit erzeugt wird.

Die Erfindung beruht auf dem Prinzip, dass mit Ultraschall, also mechanische Wellen, der Übergang von der amorphen in die kristalline Phase des Phasenwechselmaterials erheblich beschleunigt werden kann. Hier wird das Phänomen der Beta-Relaxation in Phasenwechselmaterialien ausgenutzt. Dieses Phänomen der Beta-Relaxation bedeutet, dass amorphe Materialien schnellere Atom- oder Teilchenbewegungen zeigen, die sich im Zeitmaßstab von den typischen Relaxationsprozessen unterscheiden. Aktuelle Versuche zeigen, dass eine Beschleunigung des Schaltvorgangs im Bereich um den Faktor 10, also einer Größenordnung liegt. Der Einfluss von Ultraschall beschleunigt den Schaltvorgang somit wesentlich.

Eine vorteilhafte Ausgestaltung des erfindungsgemäßen Phasenwechselspeichers besteht darin, dass Steuerungsmittel zum variablen Einstellen der Frequenz des Ultraschalls vorgesehen sind. Auf diese Weise kann die Frequenz beispielsweise auf das verwendete Material optimiert werden. Vorzugsweise können die Steuerungsmittel die Frequenz des Ultraschalls temperaturabhängig einstellen. Die Temperatur des Phasenwechselmaterials hat maßgeblichen Einfluss auf den Schaltvorgang. Hier kann es erforderlich sein, dass Temperatur und Ultraschallfrequenz aufeinander abgestimmt werden, um den Schaltvorgang zu optimieren.

Eine besonders bevorzugte Ausgestaltung des erfindungsgemäßen Phasenwechselspeichers zum nichtflüchtigen Speichern von binären Inhalten besteht darin, dass zwischen der amorphen und kristallinen Phase mehrere Phasenstufen des Phasenwechselmaterials für ein mehrstufiges Schalten zum Speichern von Inhalten vorgesehen sind.

Ausführungsbeispiel ist nachstehend unter Bezugnahme auf die beigefügte Zeichnung näher erläutert. Die Erfindung soll nicht alleine auf dieses aufgeführte Ausführungsbeispiel beschränkt werden. Es dient lediglich zur näheren Erläuterung der Erfindung.

Der Schutzbereich der vorliegenden Erfindung ist durch die beigefügten Ansprüche 1-5 definiert.

### Kurze Beschreibung der Zeichnung

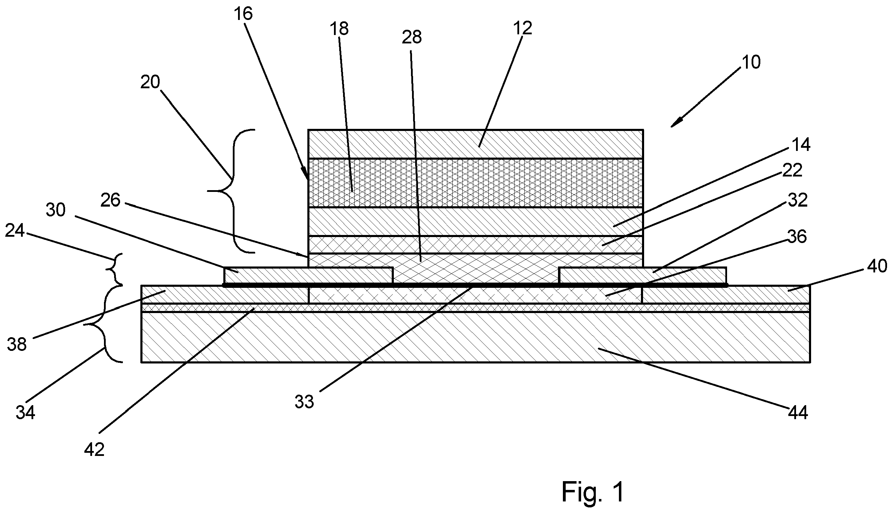

- Fig. 1: zeigt den Aufbau eines erfindungsgemäßen Phasenwechselspeichers mit einem Ultraschallgenerator.

### Bevorzugtes Ausführungsbeispiel

In Fig. 1 wird mit 10 der erfindungsgemäße Phasenwechselspeicher bezeichnet. Der Phasenwechselspeicher 10 umfasst eine erste Elektrode 12 und eine zweite Elektrode 14. Zwischen den Elektroden 12, 14 ist eine Schicht 16 eines Phasenwechselmaterials 18 vorgesehen. Die Elektrode 12, das Phasenwechselmaterial 18 und die Elektrode 14 bilden einen ersten Funktionsbereich 20 des Phasenwechselspeichers 10 und wird mit einer geschweiften Klammer kenntlich gemacht. Dieser erste Funktionsbereich 20 ist auf einer zu diesem Funktionsbereich 20 gehörenden Isolierschicht 22 angeordnet.

Ein zweiter Funktionsbereich 24, ebenfalls mit einer geschweiften Klammer kenntlich gemacht, umfasst einen Ultraschallgenerator 26. Dieser zweite Funktionsbereich 24 grenzt an die Isolierschicht 22 des ersten Funktionsbereichs 20. Der Ultraschallgenerator 26 besteht aus einer piezokristallinen Schicht 28, der von zwei weiteren Elektroden 30, 32 angesteuert wird. An die piezokristalline Schicht 28 grenzt eine Isolierschicht 33 und ein dritter Funktionsbereich 34 an.

Der dritte Funktionsbereich 34 umfasst eine Heizschicht 36 und zwei Elektroden 38, 40. Der dritte Funktionsbereich wird mit einer weiteren geschweiften Klammer dargestellt. Die Heizschicht 36 wird dabei über die zwei Heizelektroden 38, 40 betrieben. Dieser dritte Funktionsbereich enthält eine Siliziumoxydschicht 42 und wird von einer Substratschicht 44 abgeschlossen.

Die Elektroden 12, 14 schalten je nach Strompuls und dessen Dauer das Phasenwechselmaterial 18.

Bei dem Phasenwechselspeicher 10 wird ausgenutzt, dass das Phasenwechselmaterial 18 unterschiedliche elektrische Eigenschaften in der amorphen bzw. der kristallinen Phase aufweist. Der elektrische Widerstand ist im amorphen Zustand erheblich größer, als im kristallinen Zustand des Phasenwechselmaterials 18. Über die zwei Elektroden 12, 14 wird ein Strompuls auf das Phasenwechselmaterial 18 des Phasenwechselspeichers 10 gegeben. Wenn das Phasenwechselmaterial 18 mit einem relativ hohen und kurzen Strompuls beaufschlagt wird, wechselt es von der kristallinen in die amorphe Phase. Nach dem Ende des Strompulses kühlt sich das Phasenwechselmaterial 18 sehr schnell ab. Das Phasenwechselmaterial 18 verbleibt in dem amorphen Zustand und fällt nicht in die kristalline Phase zurück.

Das Phasenwechselmaterial 18 gelangt aus dem amorphen Zustand wieder zurück in den kristallinen Zustand, indem es einem längeren relativ niedrigen Strompuls ausgesetzt ist. Der Vorgang vom amorphen in den kristallinen Zustand lässt sich somit über die Dauer des Strompulses umkehren. Dadurch wird das amorphe Material über die Kristallisationstemperatur erhitzt und so lange auf dieser Temperatur gehalten, bis Kristallisation stattfindet. Der Vorgang wird beschleunigt, indem zumindest während der einzelnen Schaltvorgänge das Phasenwechselmaterial 18 mit Ultraschall beaufschlagt wird. Der Ultraschallgenerator 26 generiert mit der piezoelektrischen Schicht 28 ein auf das Phasenwechselmaterial 18 abgestimmtes Ultraschallfeld, welches auf das Phasenwechselmaterial 18 wirkt und entsprechend stimuliert. Der Schaltvorgang des Phasenwechselmaterials 18 wir dadurch erheblich beschleunigt. Da der Schaltvorgang des Phasenwechselmaterials 18 insbesondere temperaturabhängig ist, wird der Ultraschall unterschiedlich aufgenommen. Es sind daher hier nicht dargestellte Steuerungsmittel vorgesehen, die die Frequenz des Ultraschalls bzgl. der Temperatur des Phasenwechselmaterials 18 optimiert.

Die binäre Information, die ein solcher Phasenwechselspeicher 10 beinhaltet wird über eine Spannung, die z.B. über die Elektroden angelegt, wird ausgelesen. Je nach Zustand - amorph oder kristallin - des Phasenwechselmaterials 18, fließt ein anderer Strom, was nun zum Auslesen genutzt wird. Damit lässt sich über den Widerstand des Phasenwechselspeichers 10 ein binärer Zustand festlegen. Dem kristallinen Zustand wird eine binäre "Eins" und dem amorphen Zustand eine binäre "Null" zugeordnet.

### Bezugszeichenliste

- 10: Phasenwechselspeicher
- 12: Erste Elektrode
- 14: Zweite Elektrode
- 16: Schicht
- 18: Phasenwechselmaterial
- 20: Erster Funktionsbereich
- 22: Isolierschicht
- 24: Zweiter Funktionsbereich
- 26: Ultraschallgenerator
- 28: piezokristalline Schicht
- 30: Elektrode für Ultraschallgenerator
- 32: Elektrode für Ultraschallgenerator
- 33: Isolierschicht
- 34: Funktionsbereich
- 36: Heizschicht
- 38: Elektrode für Heizschicht
- 40: Elektrode für Heizschicht
- 42: Siliziumoxydschicht
- 44: Substrat

## Patentansprüche

1. Phasenwechselspeicher (10) konfiguriert zum nichtflüchtigen Speichern von binären Inhalten, welcher die binären Inhalte durch lokales Schalten eines Phasenwechselmaterials (18) zwischen einer amorphen und einer kristallinen Phase elektrisch und/oder optisch nichtflüchtig speichert, wobei der Zustand bezüglich der elektrischen Leitfähigkeit des Phasenwechselmaterials (18) und/oder bezüglich der Reflexionseigenschaften des Phasenwechselmaterials (18) den Informationsgehalt des Phasenwechselspeichers (10) festgelegt, **dadurch gekennzeichnet, dass** ein Ultraschallgenerator (26) mit einer piezoelektrischen Einheit (28) vorgesehen ist, der zumindest während des Schaltvorgangs das Phasenwechselmaterials (18) mit Ultraschall beaufschlagt und somit den Schaltvorgang beschleunigt.

2. Phasenwechselspeicher (10) zum nichtflüchtigen Speichern von binären Inhalten nach Anspruch 1, wobei ein Steuerungsmittel zum variablen Einstellen der Frequenz des Ultraschalls vorgesehen ist.

3. Phasenwechselspeicher (10) zum nichtflüchtigen Speichern von binären Inhalten nach Anspruch 2, wobei die Steuerungsmittel die Frequenz des Ultraschalls temperatur- und/oder materialabhängig einstellen,

4. Phasenwechselspeicher (10) zum nichtflüchtigen Speichern von binären Inhalten nach einem der Ansprüche 1 bis 3, wobei zwischen der amorphen und kristallinen Phase mehrere Phasenstufen des Phasenwechselmaterials (18) für ein mehrstufiges Schalten zum Speichern von Inhalten vorgesehen sind.

5. Verfahren für einen Phasenwechselspeicher (10) zum nichtflüchtigen Speichern von binären Inhalten, welcher die binären Inhalte durch lokales Schalten eines Phasenwechselmaterials (18) zwischen einer amorphen und einer kristallinen Phase elektrisch und/oder optisch nichtflüchtig speichert, wobei der Zustand bezüglich der elektrischen Leitfähigkeit des Phasenwechselmaterials (18) und/oder bezüglich der Reflexionseigenschaften des Phasenwechselmaterials den Informationsgehalt des Phasenwechselspeichers (10) festgelegt, **dadurch gekennzeichnet, dass** Ultraschall erzeugt wird, mit dem das Phasenwechselmaterial zumindest während des Schaltvorgangs beaufschlagt wird und somit den Schaltvorgang beschleunigt, wobei der Ultraschall mit einer piezoelektrischen Einheit (28) erzeugt wird.

## Claims

1. Phase-change memory (10) configured for non-volatile storage of binary contents, the phase-change memory storing the binary contents electrically and/or optically in a non-volatile manner by locally switching a phase-change material (18) between an amorphous and a crystalline phase, wherein the state with respect to the electrical conductivity of the phase-change material (18) and/or with respect to the reflection properties of the phase-change material (18) determines the information content of the phase-change memory (10), **characterized in that** an ultrasonic generator (26) with a piezoelectric unit (28) is provided, said ultrasonic generator exposing the phase-change material (18) to ultrasound at least during the switching process and thus accelerating the switching process.

2. Phase-change memory (10) for non-volatile storage of binary contents according to Claim 1, wherein a control means is provided for variably setting the frequency of the ultrasound.

3. Phase-change memory (10) for non-volatile storage of binary contents according to Claim 2, wherein the control means set the frequency of the ultrasound in a manner dependent on temperature and/or material.

4. Phase-change memory (10) for non-volatile storage of binary contents according to any one of Claims 1 to 3, wherein a plurality of phase stages of the phase-change material (18) are provided between the amorphous and crystalline phase for multi-stage switching for storing contents.

5. Method for a phase-change memory (10) for non-volatile storage of binary contents, the phase-change memory storing the binary contents electrically and/or optically in a non-volatile manner by locally switching a phase-change material (18) between an amorphous and a crystalline phase, wherein the state with respect to the electrical conductivity of the phase-change material (18) and/or with respect to the reflection properties of the phase-change material determines the information content of the phase-change memory (10), **characterized in that** ultrasound is generated, to which the phase-change material is exposed at least during the switching process and this thus accelerates the switching process, wherein the ultrasound is generated using a piezoelectric unit (28).

## Revendications

1. Mémoire à changement de phase (10) configurée pour le stockage non volatil de contenus binaires, laquelle stocke les contenus binaires de manière non volatile, électriquement et/ou optiquement, par commutation locale d'un matériau à changement de phase (18) entre une phase amorphe et une phase cristalline, l'état relatif à la conductivité électrique du matériau à changement de phase (18) et/ou relatif aux propriétés de réflexion du matériau à changement de phase (18) déterminant le contenu informatif de la mémoire à changement de phase (10), **caractérisée en ce qu'**il est prévu un générateur d'ultrasons (26) comportant une unité piézoélectrique (28), qui applique des ultrasons au matériau à changement de phase (18) au moins pendant le processus de commutation et accélère ainsi le processus de commutation.

2. Mémoire à changement de phase (10) pour le stockage non volatil de contenus binaires selon la revendication 1, dans laquelle il est prévu un moyen de commande pour le réglage variable de la fréquence des ultrasons.

3. Mémoire à changement de phase (10) pour le stockage non volatil de contenus binaires selon la revendication 2, dans laquelle les moyens de commande règlent la fréquence des ultrasons en fonction de la température et/ou du matériau.

4. Mémoire à changement de phase (10) pour le stockage non volatil de contenus binaires selon l'une quelconque des revendications 1 à 3, dans laquelle il est prévu plusieurs états de phase du matériau à changement de phase (18) entre la phase amorphe et la phase cristalline pour une commutation à niveaux multiples afin de stocker des contenus.

5. Procédé pour une mémoire à changement de phase (10) pour le stockage non volatil de contenus binaires, laquelle stocke les contenus binaires de manière non volatile, électriquement et/ou optiquement, par commutation locale d'un matériau à changement de phase (18) entre une phase amorphe et une phase cristalline, l'état relatif à la conductivité électrique du matériau à changement de phase (18) et/ou relatif aux propriétés de réflexion du matériau à changement de phase déterminant le contenu informatif de la mémoire à changement de phase (10), **caractérisé en ce que** des ultrasons sont générés, auxquels le matériau à changement de phase est exposé au moins pendant le processus de commutation et accélérant ainsi le processus de commutation, les ultrasons étant générés au moyen d'une unité piézoélectrique (28).
